# EUROPEAN PATENT APPLICATION

(11) **EP 2 426 801 A1**
(43) Date of publication of application: **07.03.2012**
(21) Application number: 10175089.1
(22) Date of filing: 02.09.2010
(51) Int. Cl.: H02G 5/10

(54) **Busbar, method for cooling thereof and electrical apparatus**

(71) Applicant: ABB Research Ltd., 8050 Zürich (CH)
(72) Inventor: Iordanidis, Arthouros, CH-5400, Baden (CH); Werder Schläpfer, Thomas, CH-5000, Aarau (CH); Kallweit, Rene, CH-8200, Schaffhausen (CH); Galletti, Bernardo, CH-5415, Nussbaumen (CH); Kruesi, Urs, CH-8542, Wiesendangen (CH)
(74) Representative: ABB Patent Attorneys

(57) **Abstract**

A current-carrying segment (1) comprises at least one current conductor (2), a shield (3) at least partially enclosing the current conductor (2) and a housing (4) for the current conductor (2). The housing (4) encloses the shield (3). A first space (5) between the current conductor (2) and the shield (3) and a second space (6) between the shield (3) and the housing (4) are filled with an insulating fluid. The current-carrying segment (1) comprises at least one pipe (9) for cooling the current conductor (2), arranged at least inside the first space (5), and the pipe (9) comprises at least one first pipe section (1a) and at least one second pipe section (1b). The first pipe section (1a) extends through the shield (3). The second pipe section (1b) encloses at least a portion (2a) of the current conductor (2).

## Description

### Background

The invention resides in the field of medium and high voltage technologies and relates to a current-carrying segment, to an electrical apparatus, such as a gas insulated switchgear, and to a method for cooling a current-carrying segment, all according to the preamble of the corresponding independent claims.

### Prior art

Gas insulated switchgear has the main function of protecting power supply systems, for example in case of short-circuits and overload fault currents, while maintaining service to unaffected circuits. Switchgear also provides isolation of circuits from power supplies. It is also used to enhance system availability by allowing more than one source to feed a load. There are several types of switchgear, of which gas insulated switchgear is one type. The preferred gas used for isolating conductors and contacts is SF₆ (sulphur hexafluoride), but other fluids, like insulating oil, are also used. One aspect to be considered when designing switchgear is the fact that resistive or ohmic losses in the conductors and contact resistances between different parts lead to a heating up of the switchgear and may further lead to failure of the system. The heat level depends, amongst others, on the current value through the conductors in relation to the resistive losses. Therefore, it is in some cases mandatory to provide appropriate cooling of the conductors in order to prevent damage and to comply with standards defining limits for acceptable temperatures. For example, at low currents natural convection of the insulating gas may be sufficient for cooling the conductors. However, as the dissipated power scales with the squared applied current, more powerful cooling mechanisms are required above a certain current level.

The German patent application DE 10 2008 049 435 A1 discloses a busbar arrangement comprising at least two partial conductors with a gap between one another. The busbar is enclosed in an encapsulating housing and is surrounded by insulating gas. By virtue of the disclosed arrangement of the partial conductors, a better flow of the gas is achieved and consequently a better cooling of the partial conductors results. A disadvantage of the proposed enhancement is the fact that the partial conductors are bound to a certain configuration. Furthermore, the arrangement does not account for enhancing the cooling of single conductors.

### Description of the invention

It is an objective of the present invention to provide a current-carrying segment and an electrical apparatus with such segments having an enhanced cooling mechanism.

This is achieved according to the invention by providing a current-carrying segment comprising at least a current conductor, a shield at least partially enclosing the current conductor, and a housing for the current conductor, in particular a gas-tight housing for encapsulating the current conductor from the environment. The housing encloses the shield. A first space between the current conductor and the shield and a second space between the shield and the housing are filled with an insulating fluid. The current-carrying segment comprises at least one pipe for cooling the current conductor, arranged at least inside the first space. The pipe comprises at least one first pipe section having an entrance opening for the fluid and at least at least one second pipe section having an exit opening for the fluid. The first pipe section extends through the shield and the second pipe section encloses at least a portion of the current conductor.

Furthermore, the objective is achieved by providing an electrical apparatus comprising at least one current-carrying segment according to the invention. The electrical apparatus is, in particular, a gas insulated switchgear, generator circuit breaker, high-voltage circuit breaker or load-break disconnector.

A further objective of the invention is to provide a method for efficiently cooling electrical apparatuses. This objective is achieved by a method for cooling at least a current conductor of an electrical apparatus according to the invention. In a first step a current is applied to the current conductor, such that it heats up due to its losses, e.g. resistive losses or inductive losses. In a second step the current conductor is cooled by generating a convective flow of the insulating fluid in such a way that cold fluid from a bottom part of the second space with respect to the gravity force flows substantially against the direction of the gravity force into the lower pipe section, subsequently into the second pipe section through a space between inner walls of the second pipe section and outer walls of and/or slits in the enclosed portion of the current conductor, and finally out into the first or the second space.

Furthermore, a use of at least one current-carrying segment according to the invention for providing cooling of a generator circuit breaker, high voltage circuit breaker or load-break disconnector is disclosed.

The advantage of said current-carrying segment or apparatus, respectively, is the possibility of efficiently cooling a current conductor by making use of the fact that the density of the fluid decreases with increasing temperature. Thus, the fluid rises inside the pipe when the fluid is heated up by the conductor. As a consequence, cold fluid from the bottom of the first and/or second space is sucked into the pipe. The heated fluid which has travelled upwards exits the pipe, cools down again and drops towards the bottom of the first and/or second space. In this way, a fluid stream or fluid circulation takes place.

Particularly in case of the fluid being a gas, the pipe acts as a "chimney", using the chimney effect in the pipe for cooling the current conductor. As is known already, cold gas is heavier than hot gas. Accordingly, cold insulating gas inside the housing tends to concentrate at the bottom of the housing and of the shield. Contrary to this, hot gas rises to the top of the housing and of the shield. In the presence of non-uniform temperatures inside the switchgear, which is always the case due to said hot spots, there is a natural gas circulation, or thermal convection, occurring separately inside the first space and the second space. Bearing this in mind and considering a conductor lacking the pipe of the invention, gas located in the vicinity of a hot area at the surface of the conductor heats up and rises immediately to the top of the shield only or to the top of the housing only. A gas transfer, which is favourable for cooling the conductor, can substantially take place merely in the upper half of the first or second space. Thus, conventional cooling is inefficient, because the coldest gas at the bottom of the housing, which has the highest cooling potential, is not used, and at least in some cases natural convection occurs only separately inside the shield and, if at all, outside the shield.

By using the pipe according to the invention it is possible to "tap" the colder fluid pool at the bottom of the housing and make use of its high cooling potential, as well. By enclosing a portion of the conductor, preferably a hot area, inside the pipe and having the pipe extending, in its longitudinal direction, from the vicinity of the bottom of the housing towards the top of the housing or the shield, it is possible to force the cold gas at the bottom to travel through the pipe and efficiently cool the hot area of the conductor. This is achieved, because hot fluid from around the conductor surface in the hot area will rise towards the top through the pipe and will create an underpressure at its former location, such that colder fluid is sucked in through the entrance opening of the first pipe section, which reaches into a lower part of the second space, and is convectively transported through the pipe, thereby leveling out the pressure distribution. Thus, a pumping effect is created through the pipe, because the pipe extends at its entrance opening into the colder gas reservoir at the lower region of the encapsulation and reaches at its exit opening into a warmer gas reservoir at an upper region of the encapsulation.

### Short description of the drawings

Further embodiments, advantages and applications of the invention result from the dependent claims and from the now following description by means of the figures. It is shown in:
Fig. 1 a cross section of a simplified fluid insulated electrical apparatus,
Fig. 2 a longitudinal sectional view of a current-carrying segment according to the prior art,
Fig. 3 a longitudinal sectional view of a first embodiment of a current-carrying segment according to the invention,
Fig. 4 a perspective view of the first embodiment of the current-carrying segment according to the invention, and
Figs. 5-8 longitudinal sectional views of a second, third, fourth and fifth embodiment of a current-carrying segment according to the invention.

Elements which are not necessary for the understanding of the invention are partly not shown. Same elements are named by same reference symbols which may also be omitted in subsequent drawings for simplicity. The explained embodiments are exemplary for the subject of the invention and have no limiting effect; the invention may be executed in different ways within the scope of the claims, e.g. for the description of the figures the insulating fluid is assumed to be gas, however another appropriate insulating fluid like oil may also be used.

### Ways of carrying out the invention

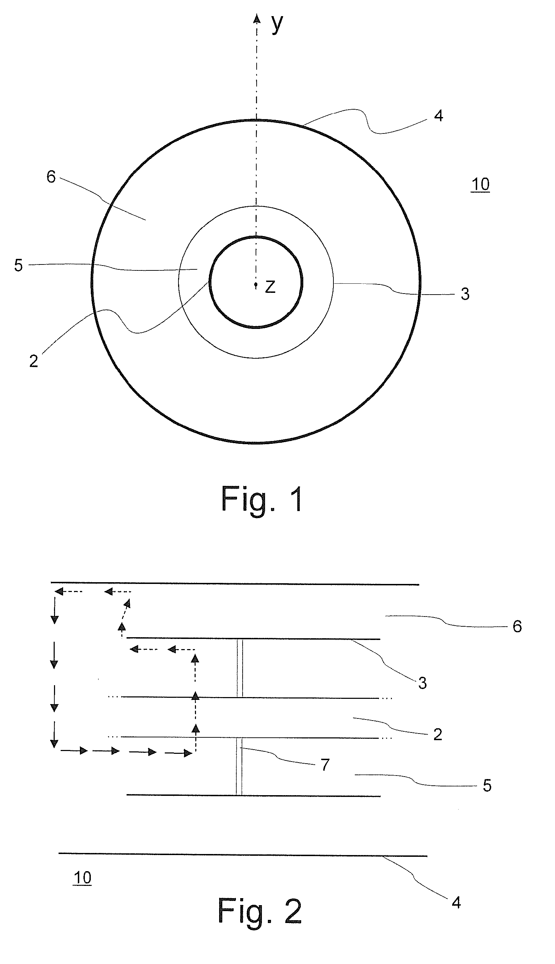

Fig. 1 shows a cross section of a simplified gas insulated switchgear. A current conductor 2 extends in a longitudinal direction z. A shield 3 partially encloses the current conductor 2. A housing 4 for sealing off or encapsulating the conductor segment from the environment encloses the shield 3. A first space 5 between the current conductor 2 and the shield 3 and a second space 6 between the shield 3 and the housing 4 are filled with an insulating gas, preferably SF₆. The shield 3 prevents electrical discharges between the conductor 2 and the housing 4. The direction y corresponds to the vertical direction.

Fig. 2 shows a longitudinal sectional view of a Current-Carrying segment according to the prior art. The shield 3 is supported by holder elements 7. The insulating gas located both in the first and the second space 5, 6 cools the current conductor 2. In Fig. 2 it is shown in a simplified manner how the cooling is accomplished. The arrows denote the path of the gas flow. As known, there is a gas circulation inside the first and the second space 5, 6 because of temperature differences within the entire arrangement. For this and the following figures, dashed arrows represent hot gas and lined arrows represent cold or cooling gas. Gas located close to the outer conductor surface is heated up by the conductor, rises to the upper part of the shield 3 and escapes to the upper part of the housing 4 through an opening in the shield 3. This is denoted by the dashed arrows. During this circulation, the gas cools down again and drops to a level located slightly below the conductor 2. During its drop, the gas is again heated up by the conductor 2 and rises again. Gas located in the lower part of the first space 5 and of the second space 6 is therefore hardly circulated, but is rather excluded from gas circulation.

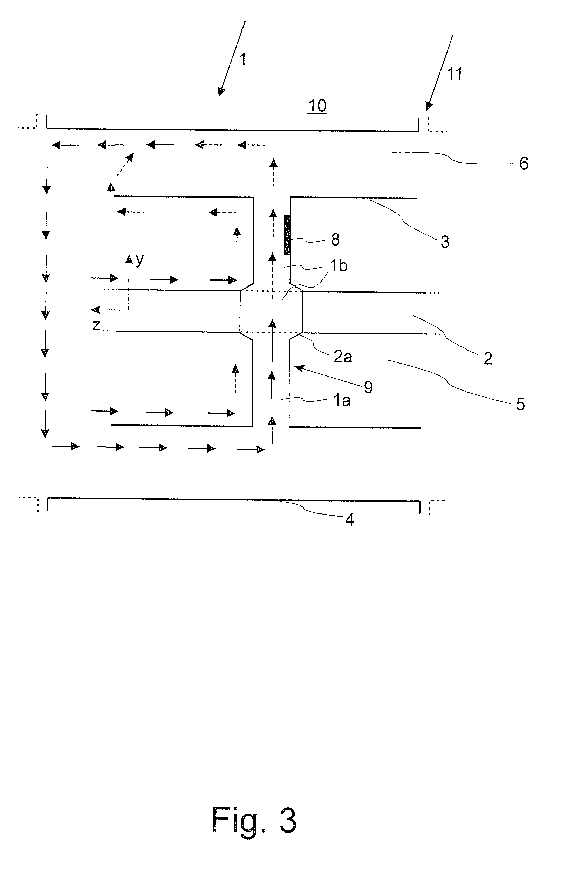

Fig. 3 shows a longitudinal sectional view of a first embodiment of an electrical apparatus 11, such as a gas insulated switchgear, circuit breaker or disconnector, comprising at least one conductor segment 1 according to the invention. The arrangement of the current conductor 2, shield 3 and housing 4 is the same as described above. In addition, a pipe 9 for cooling a portion 2a of the conductor 2 is arranged inside the shield 3. It comprises a first pipe section 1a and a second pipe section 1b. The pipe is open, typically at end faces, and may transfer a fluid. Preferably, the pipe is arranged substantially vertically. In particular, the first and/or the second pipe sections 1a, 1b is or are elongated in a substantially vertical direction, however they may also run obliquely with respect to the vertical axis y. Both pipe sections 1a, 1b extend through the shield 3. The second pipe section 1b encloses a portion 2a of the current conductor 2 and, in particular, hermetically encloses said portion 2a of the current conductor 2. Fig. 3 also shows the gas flow using the same arrow types as Fig. 2; hot gas is denoted by dashed arrows and cold gas by lined arrows. For all subsequent figures, at least one hot area of the conductor 2 is assumed to be located within the portion 2a of the conductor 2. A hot area is defined as a part of the conductor 2 having a temperature above a specified level. Particularly, hot areas develop in the vicinity of contacts or of material impurities of the conductor 2. The hot areas are preferably determined by means of, particularly computer-aided, thermodynamics simulations.

As can be seen in Fig. 3, starting from the upper surface of the enclosed portion 2a of the conductor 2, the gas is heated up and rises. As the gas path only leads through the pipe 9, it escapes directly into the second space 6 and continues circulating substantially along the cold housing 4. Of course, the gas flow is shown in a simplified manner, whereas in reality the flow may differ and may, for example, contain swirls or small swirls. During the circulation close to the upper inner wall of the housing 4 the gas cools down again. This is also due to the fact that the housing 4 conducts a part of the heat of the rising hot gas to the environment 10. During the process of cooling down, the gas drops in the direction towards the bottom of the housing 4. Meanwhile, because of the underpressure in the pipe 9, cold gas from the "cold gas sea" at the bottom of the housing is sucked into the pipe though one or several entrance openings and cools the enclosed portion 2a. As can be seen by comparing Fig. 2 and Fig. 3, the present invention makes use of the much colder gas located at the bottom of the housing 4 for a more efficient cooling of the conductor portion 2a.

The extension of the second pipe section 1b through the shield 3 is particularly preferred, as it additionally accelerates the gas and takes it out to the second space, such that the gas has more time to cool off.

The cross section or distribution of cross sections of the pipe 9 along its longitudinal extent necessary for an efficient cooling may be determined depending on at least one electrical and/or material parameter, such as e.g. ohmic losses in or around the current-carrying segment, density and heat capacity of the cooling gas at a given pressure, and/or velocity of the fluid.

An additional cooling is reached, as a side effect of the invention, by the fact that the walls of the pipe 9 provide an additional cooling effect. As the first and the second space 5, 6 are thermally connected with each other, the pipe walls radiate heat from the pipe 9 to the outside, thus creating an additional gas circulation on the outer sides of the pipe 9, which is also shown in Fig. 3.

The gas streaming into the upper part of the second space 6 is led back to the lower part of the second space 6.

In this embodiment, the pipe 9 comprises optionally in addition a fin 8, extending into the pipe 9 and preferably extending vertically. The fin 8 increases the heat transfer to the wall. Of course, a plurality of fins 8 may be attached to the wall of the pipe 9, also in the lower section 1a. The fin 8 or fins may also be arranged to extend out from the pipe 9 and to protrude into the first space 5. Furthermore, fins 8 may be arranged on the inside and the outside at the walls of the pipe 9. In another embodiment the fin 8 may run substantially helically, however it is generally preferred that the fin runs substantially vertically in order to prevent gas from being hindered from rising up.

The pipe 9 is mechanically connected to the current conductor 2 and the shield 3 (not shown), thereby forming a support for the shield 3. Advantageously, the pipe also replaces the holder elements 7 of Fig. 2, thus fulfilling two tasks at a time, i.e. cooling the conductor 2 and self-dependent supporting the shield 3.

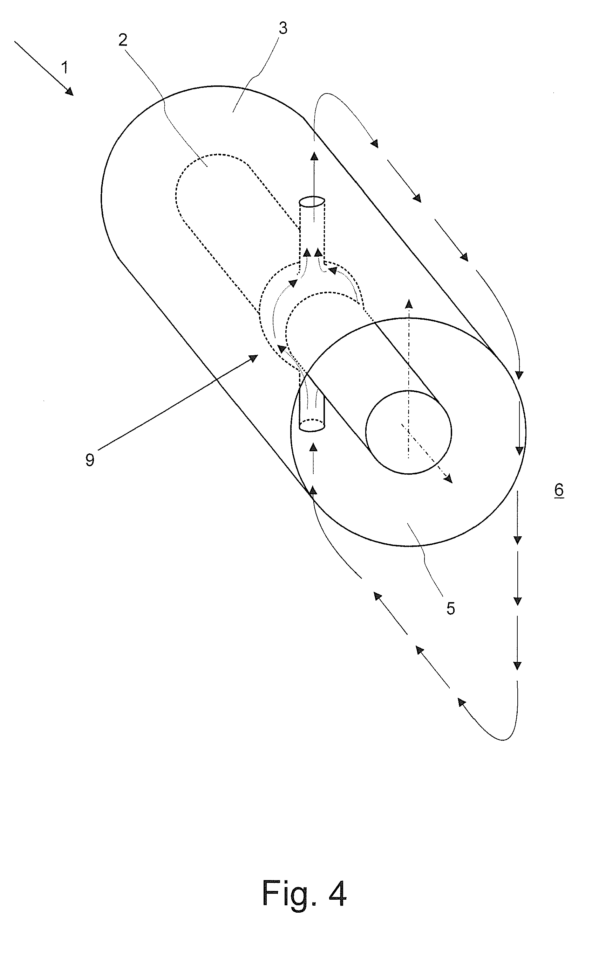

Fig. 4 shows a perspective view of the first embodiment of the current-carrying segment 1 according to the invention. This figure shows the position of the pipe 9 inside the shield 3 in a more illustrative way. For reasons of clarity, the housing 4 is omitted. Also, the path of the gas circulation inside the pipe 9 can be seen in a better way; the dotted arrows show how the heated gas flows around the enclosed portion 2a of the conductor 2. As shown, in this embodiment the second pipe section 1b of the pipe 9 encloses a substantially toroidal space around the conductor 2. Alternatively or in addition, the second pipe section 1b may enclose a portion 2a of the current-carrying segment 1 which has slits (not shown), preferably vertical slits, for passing through the fluid. The majority of the gas circulation takes place through the second space 6. The additional circulation inside the first space 5 of Fig. 3 is not shown here for clarity reasons.

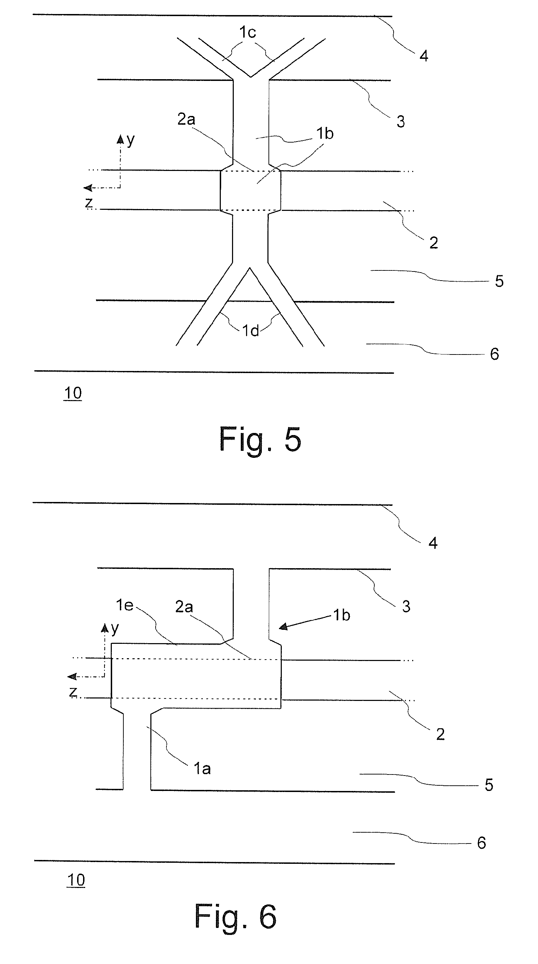

Fig. 5 shows a longitudinal sectional view of a second embodiment of a current-carrying segment 1 according to the invention. The arrangement is broadly the same as the one in Fig. 3, except for the lower section 1a of the pipe 9. Firstly, the first pipe section 1a protrudes beyond the shield 3 and into the second space 6 here. This advantageously prolongs the path of the gas and allows "tapping" gas from a lower or the lowest region of the second space 6, where colder or the coldest gas is located. Secondly, the first pipe section 1a has two entrance openings 1d facing the housing 4.

This advantageously allows tapping cold gas from a larger region, i.e. from a larger portion or area or axial extent of the lowest region of the second space 6. In another embodiment the second pipe section 1b particularly protrudes beyond the shield 3 and into an upper part of the second space 6. Furthermore, the second pipe section 1b has at least two exit openings 1c facing towards the housing 4. This has the advantage that a less turbulent stream or gas flow is created in an upper or the top part of the second space 6 and consequently that the heat is led further and/or faster away from the region of the chimney or pipe 9.

Fig. 6 shows a longitudinal sectional view of a third embodiment of a current-carrying segment 1 according to the invention. The arrangement is broadly the same as the one in Fig. 3, except for the second pipe section 1b of the pipe 9. The second pipe section 1b comprises a cylinder 1e arranged substantially concentrically with respect to the portion 2a of the current conductor 2 and forming an enclosed space around it. The first pipe section 1a is connected substantially to one axial end of the cylinder 1e. In this embodiment, the second pipe section 1b comprising the cylinder 1e also comprises an extension, extending from the other axial end of the cylinder 1e through the shield 3, preferably in vertical upward direction.

By the invention, at least one hot spot of the current conductor 2 is cooled by means of the pipe 9, but a plurality of hot spots may particularly be cooled by means of a single pipe 9. The third embodiment described above is advantageous for cooling such a plurality of hot spots. The radial distance between an inner wall of the cylinder 1e to the conductor is chosen depending on the length of the cylinder 1e, thus depending on the horizontal path which has to be travelled by the gas in order to escape to the top and on the temperatures to be dissipated in that region.

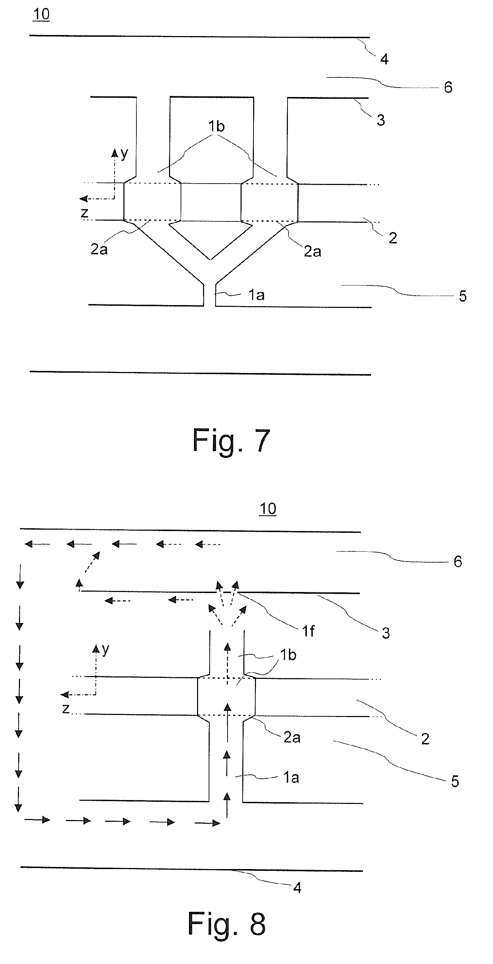

Fig. 7 shows a longitudinal sectional view of a fourth embodiment of a current-carrying segment 1 according to the invention. The arrangement is broadly the same as the one in Fig. 3, except for the second pipe section 1b of the pipe 9. Here, two second pipe sections 1b each enclosing a distinct portion 2a of the current conductor 2 are connected to the first pipe section 1a. Of course more second pipe sections 1b are possible, as well. This embodiment particularly accounts for hot spots which are located at a too long distance from each other to be efficiently cooled by means of a single pipe according to one of the previous embodiments of the invention, but still are at a mutual distance allowing the usage of a single pipe 9 with a single first pipe section 1a and two or more second pipe sections 1b.

Fig. 8 shows a longitudinal sectional view of a fifth embodiment of a current-carrying segment 1 according to the invention. The arrangement is broadly the same as the one in Fig. 3, except for the second pipe section 1b of the pipe 9. Here, the second pipe section 1b protrudes only into the first space 5. In this case the gas rises towards the upper area of the shield 3 and escapes to or into the second space 6 via an opening connecting the first and the second space 5, 6, as shown on the left and the right side of the current-carrying segment 1. Optionally or additionally, in case the second pipe section 1b ends inside the first space 5, further openings 1f may be provided in the shield 3 substantially above the exit opening 1c of the second pipe section 1b, such that gas may directly rise through these openings 1f and enter the second space 6. The arrows represent again the gas flow in a simplified way.

The current-carrying conductor segment 1 of the invention can also be used for a generator circuit breaker or any hot parts of it. Another application is to use the current-carrying conductor segment 1 for a high voltage circuit breaker or load-break isolator or any hot parts of them, or for other high voltage or medium voltage equipment requiring and profiting from passive chimney-effect cooling as provided for by the pipe 9.

## Claims

1. Current-carrying segment (1) comprising at least a current conductor (2), a shield (3) at least partially enclosing the current conductor (2), and a housing (4) for the current conductor (2), said housing (4) enclosing the shield (3), wherein a first space (5) between the current conductor (2) and the shield (3) and a second space (6) between the shield (3) and the housing (4) are filled with an insulating fluid, **characterized in that** the current-carrying segment (1) comprises at least one pipe (9) for cooling the current conductor (2), the pipe (9) being arranged at least inside the first space (5) and comprising at least one first pipe section (1a) having an entrance opening (1d) for the fluid and at least one second pipe section (1b) having an exit opening (1c) for the fluid, with the first pipe section (1a) extending through the shield (3) and the second pipe section (1b) enclosing at least a portion (2a) of the current conductor (2).

2. Current-carrying segment (1) according to claim 1, wherein the second pipe section (1b) extends through the shield (3) and, in particular, protrudes beyond the shield (3) and into the second space (6), in particular wherein the second pipe section (1b) has at least two exit openings facing towards the housing (4).

3. Current-carrying segment (1) according to any of the preceding claims, wherein the pipe (9) is arranged substantially vertically, and in particular wherein the first pipe section (1a) and/or the second pipe section (1b) is or are arranged substantially vertically.

4. Current-carrying segment (1) according to any of the preceding claims, wherein the pipe (9) is mechanically connected to the current conductor (2) and the shield (3) and forms a support, in particular the sole support, for the shield (3).

5. Current-carrying segment (1) according to any of the preceding claims, wherein the first pipe section (1a) protrudes beyond the shield (3) and into the second space (6), and in particular wherein the first pipe section (1a) has at least two entrance openings (1d) facing towards the housing (4).

6. Current-carrying segment (1) according to any of the preceding claims, wherein the first pipe section (1a) extends into a bottom part of the second space (6), and/or the second pipe section (1a) extends into an upper part of the second space (6).

7. Current-carrying segment (1) according to any of the preceding claims, wherein the second pipe section (1b) encloses a substantially toroidal space around the portion (2a) of the current conductor (2), and/or wherein the second pipe section (1b) encloses a part of the segment (1) having slits, preferably vertical slits, for passing through the fluid.

8. Current-carrying segment (1) according to any of the preceding claims, wherein the second pipe section (1b) comprises a cylinder (1e) arranged substantially concentrically with respect to the portion (2a) of the current conductor (2), and the first pipe section (1a) is connected substantially to one axial end of the cylinder (1e).

9. Current-carrying segment (1) according to any of the preceding claims, wherein the second pipe section (1b) has at least two exit openings (1c) facing towards the housing (4), and/or at least two second pipe sections (1b) are present, are each enclosing a distinct portion (2a) of the current conductor (2), and are fluidally connected to the first pipe section (1a).

10. Current-carrying segment (1) according to any of the preceding claims, wherein the pipe (9) comprises at least one fin (8), and in particular wherein the fin (8) extends into the pipe and/or out of the pipe (9) into the first space (5) .

11. Current-carrying segment (1) according to claim 9, wherein the fin (8) extends substantially vertically (y) or runs substantially helically.

12. Electrical apparatus (11) comprising at least one current-carrying segment (1) according to any of the preceding claims.

13. Electrical apparatus (11) according to claim 12, wherein the electrical apparatus (11) is a gas insulated switchgear, generator circuit breaker, high voltage circuit breaker, or load-break disconnector.

14. Method for cooling at least one conductor (2) of an electrical apparatus (11) according to claim 12 or 13, comprising the steps of:
a) applying a current to the conductor (2), such that it heats up due to losses; and
**characterized in** the subsequent step of:
b) cooling the conductor (2) by generating a convective flow of the insulating fluid in such a way that fluid from a bottom part of the second space (6) with respect to the gravity force flows substantially against the direction of the gravity force (y) into the first pipe section (1a), subsequently into the second pipe section (1b) and through a space between inner walls of the second pipe section (1b) and outer walls of and/or slits in the enclosed portion (2a) of the conductor (2), and finally out into the first space (5) or the second space (6).

15. Method according to claim 14, wherein the fluid flowing into a top part of the second space (6) is led back to the bottom part of the second space (6).

16. Method according to claim 14 or 15, wherein at least one hot spot of the conductor (2) is cooled by means of the pipe (9), and in particular wherein a plurality of hot spots are cooled by a single pipe (9).
